(19)

Europäisches
Patentamt
European
Patent Office
Office européen
des brevets

(11) **EP 4 657 758 A1**

(12) **EUROPEAN PATENT APPLICATION**

(43) Date of publication:
**03.12.2025 Bulletin 2025/49**

(21) Application number: **25169384.2**

(22) Date of filing: **09.04.2025**

(51) International Patent Classification (IPC):
*H03M 13/09* (2006.01)    *H03M 13/15* (2006.01)
*H03M 13/29* (2006.01)    *H03M 13/00* (2006.01)

(52) Cooperative Patent Classification (CPC):
**H03M 13/09; H03M 13/1515; H03M 13/158;**
**H03M 13/159; H03M 13/2906; H03M 13/617;**
**H03M 13/6502**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority: **30.05.2024    KR 20240071008**
**14.08.2024    KR 20240109114**

(71) Applicant: **Samsung Electronics Co., Ltd.**
**Suwon-si, Gyeonggi-do 16677 (KR)**

(72) Inventors:
• **JEON, Kijun**
**16677 Suwon-si, Gyeonggi-do (KR)**

• **KWON, Soonkwan**
**16677 Suwon-si, Gyeonggi-do (KR)**
• **KIM, Seongyoon**
**16677 Suwon-si, Gyeonggi-do (KR)**
• **SHIN, Dongmin**
**16677 Suwon-si, Gyeonggi-do (KR)**
• **JUN, Bohwan**
**16677 Suwon-si, Gyeonggi-do (KR)**
• **CHUNG, Youngjin**
**16677 Suwon-si, Gyeonggi-do (KR)**

(74) Representative: **Kuhnen & Wacker**
**Patent- und Rechtsanwaltsbüro PartG mbB**
**Prinz-Ludwig-Straße 40A**
**85354 Freising (DE)**

(54) **ERROR CORRECTION CODE CIRCUIT, OPERATING METHOD THEREOF, AND STORAGE DEVICE**

(57)    An error correction code circuit (100) for correcting an error of a codeword based on an element of a Galois field GF($2^m$), wherein m is an integer comprises a forward error correction, FEC, decoder (122) configured to substitute the element into a first generator polynomial with respect to a first primitive polynomial, among primitive polynomials having a leading term m, that has a calculation complexity less than a reference value, correct the error of the codeword based on a result of the first generator polynomial, and output an error-corrected cyclic redundancy check, CRC, codeword; and a CRC decoder (121) configured to substitute the element into a second generator polynomial with respect to a second primitive polynomial among the primitive polynomials that has a calculation complexity less than the reference value and is different from the first primitive polynomial, detect an error of the CRC codeword based on a result of the second generator polynomial, and output an error-detected message. The second generator polynomial follows

$$g_2(x) = \sum_{i=0}^{2t_{crc}} g_i^2 x^i$$

where $t_{crc}$ denotes a number of error-detectable symbols of the CRC decoder (121, 1400), and coefficients $g_i^2$ of the second generator polynomial satisfy

$$g_s^2 = g_{2t_{crc}-s}^2,$$

*where* $0 \leq s \leq t_{crc}$ - 1.

**(Cont. next page)**

# FIG. 1

100

110

ECC ENCODER

MSG → | 111 CRC ENCODER | → CRC_CW → | 112 FEC ENCODER | → CW

120

ECC DECODER

MSG ← | 121 CRC DECODER | ← CRC_CW ← | 122 FEC DECODER | ← CW

**Description**

BACKGROUND

The present disclosure relates to an electronic device, and more particularly, to an error correction code circuit, an operating method thereof, and a storage device.

Semiconductor memory devices include volatile memory devices and nonvolatile memory devices. Data read from a semiconductor memory device may have errors therein due to various reasons. To correct errors, research on error correction codes, such as a Bose-Chaudhuri-Hocquenghem (BCH) code, a low density parity check (LDPC) code, and a turbo code, have been conducted.

A Reed-Solomon (RS) code is a linear block code that is a non-binary version of the BCH code. The RS code is a type of block error correction code used in, for example, hard disks, compact discs (CDs), digital versatile discs (DVDs), barcodes, wireless and mobile communication, satellite communication, digital televisions, and the like, of digital communication and data storage. An RS encoder obtains a certain block of data and adds spare bits to the data to generate a codeword. An RS decoder receives each block data and parity check bits and restores original data when an error occurs.

Along with the development of the semiconductor manufacturing technology, the operating speed of a host device has increased, and the volume of content used in the host device has increased. Accordingly, a storage device with increased operating speed, and a method of efficiently designing an RS code to correct an error are needed.

SUMMARY

One or more example embodiments provide an error correction code circuit, an operating method thereof, and a storage device.

According to an aspect of an example embodiment, an error correction code circuit for correcting an error of a codeword based on an element of a Galois field GF($2^m$) (m is an integer), the error correction code circuit including: a forward error correction (FEC) decoder configured to substitute the element into a first generator polynomial with respect to a first primitive polynomial, among primitive polynomials having a leading term m, that has a calculation complexity less than a reference value, correct the error of the codeword based on a result of the first generator polynomial, and output an error-corrected cyclic redundancy check (CRC) codeword; and a CRC decoder configured to substitute the element into a second generator polynomial with respect to a second primitive polynomial among the primitive polynomials that has a calculation complexity less than the reference value and is different from the first primitive polynomial, detect an error of the CRC codeword based on a result of the second generator polynomial, and output an error-detected message. The second generator polynomial follows $g_2(x) = \sum_{i=0}^{2t_{crc}} g_i^2 x^i$, where $t_{crc}$ denotes a number of error-detectable symbols of the CRC decoder, and coefficients $g_i^2$ of the second generator polynomial satisfy $g_s^2 = g_{2t_{crc}-s}^2$, where $0 \leq s \leq t_{crc}$ - 1.

According to another aspect of an example embodiment, an operating method of an error correction code circuit for correcting an error of a codeword based on an element of a Galois field GF($2^m$) (m is an integer), the operating method includes: an FEC decoding operation of correcting the error of the codeword based on the element and a first generator polynomial with respect to a first primitive polynomial, among primitive polynomials having a leading term m, that has a calculation complexity less than a reference value; and a CRC decoding operation of detecting an error of a CRC codeword obtained by correcting the error of the codeword in the FEC decoding operation, based on the element and a second generator polynomial with respect to a second primitive polynomial, among the primitive polynomials, that has a calculation complexity less than the reference value and is different from the first primitive polynomial. The second generator polynomial follows $g_2(x) = \sum_{i=0}^{2t_{crc}} g_i^2 x^i$, where $t_{crc}$ denotes a number of error-detectable symbols in the CRC decoding operation, and coefficients $g_i^2$ of the second generator polynomial satisfy $g_s^2 = g_{2t_{crc}-s}^2$, where $0 \leq s \leq t_{crc}$ - 1.

According to another aspect of an example embodiment, a storage device includes: a memory storing a codeword; and a memory controller configured to correct an error of the codeword based on an element of a Galois field GF($2^m$) (m is an integer). The memory controller includes: an FEC decoder configured to substitute the element into a first generator polynomial with respect to a first primitive polynomial, among primitive polynomials having a leading term m, that has a multiplication complexity less than a reference value, correct the error of the codeword based on a result of the first generator polynomial, and output an error-corrected CRC codeword; and a CRC decoder configured to substitute the element into a second generator polynomial with respect to a second primitive polynomial among the primitive polynomials that has a multiplication complexity less than the reference value and is different from the first primitive polynomial, detect an error of the CRC codeword based on a result of the second generator polynomial, and output an error-detected message. The second generator polynomial follows $g_2(x) = \sum_{i=0}^{2t_{crc}} g_i^2 x^i$, where $t_{crc}$ denotes a number of error-detectable symbols of the CRC decoder, and coefficients $g_i^2$ of the second generator polynomial satisfy $g_s^2 = g_{2t_{crc}-s}^2$, where $0 \le s \le t_{crc}$ - 1.

## BRIEF DESCRIPTION OF DRAWINGS

The above and other aspects will be more apparent from the following description of example embodiments, taken in conjunction with the accompanying drawings, in which:

FIG. 1 is a block diagram of an error correction code circuit according to example embodiments;
FIG. 2 is a flowchart of a method of designing an error correction code circuit, according to example embodiments;
FIG. 3 illustrates a table including a primitive polynomial pool according to example embodiments;
FIGS. 4 and 5 illustrate tables including intermediate results in a multiplication operation between symbols, according to example embodiments;
FIG. 6 illustrates a table including coefficients of a code polynomial with respect to each of example primitive polynomials, according to example embodiments;
FIG. 7 illustrates a table including the complexity and the depth of a multiplication in a primitive polynomial pool, according to example embodiments;
FIG. 8 illustrates a generator polynomial with respect to each of example primitive polynomials, according to example embodiments;
FIG. 9 is a block diagram of a forward error correction (FEC) encoder according to example embodiments;
FIGS. 10 and 11 are block diagrams of a cyclic redundancy check (CRC) encoder according to example embodiments;
FIG. 12 is a block diagram of an FEC decoder according to example embodiments;
FIG. 13 is a block diagram of a syndrome calculation circuit according to example embodiments;
FIG. 14 is a block diagram of a CRC decoder according to example embodiments;
FIG. 15 is a block diagram of a decoding circuit according to example embodiments;
FIG. 16 is a block diagram of a storage system according to example embodiments; and
FIG. 17 is a flowchart of an operating method of an error correction code circuit, according to example embodiments.

## DETAILED DESCRIPTION

Hereinafter, example embodiments are described in detail with reference to the accompanying drawings. Embodiments described herein are example embodiments, and thus, the present disclosure is not limited thereto, and may be realized in various other forms. Each example embodiment provided in the following description is not excluded from being associated with one or more features of another example or another example embodiment also provided herein or not provided herein but consistent with the present disclosure. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

Expressions, such as "first" and "second", used in the specification can be used to describe various elements without regarding to sequence and/or importance and do not limit corresponding elements but are used only to classify a certain element from another element. For example, first user equipment and second user equipment may indicate different pieces of user equipment without regard to sequence or importance. For example, a first element may be referred to as a second element without going beyond the right scope of the specification, and likewise, the second element may be referred to as the first element.

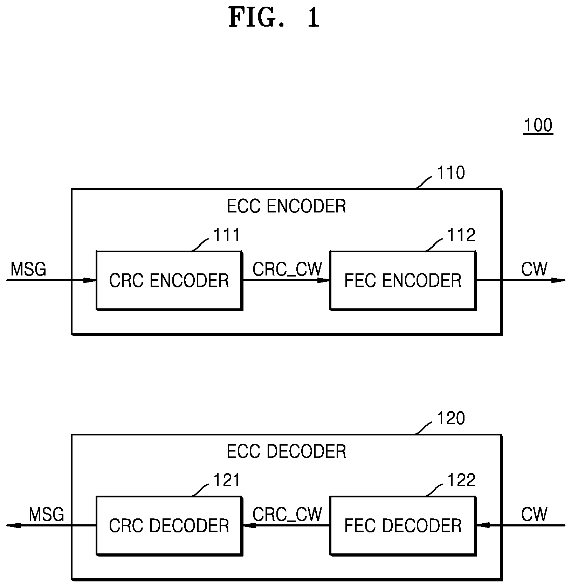

FIG. 1 is a block diagram of an error correction code (ECC) circuit 100 according to example embodiments.

Referring to FIG. 1, the ECC circuit 100 may perform an ECC encoding operation on a user data set provided from the outside (e.g., a host) and generate a parity data set in a write operation. The ECC circuit 100 may output the user data set and the parity data set. The user data set may be referred to as a message MSG. The user data set and the parity data set may be included in a codeword CW. The codeword CW may be provided to a memory, a memory chip, a memory module, or the like. The message MSG of the codeword CW may be stored in a memory cell array, a data chip, or the like storing user data. The parity data set of the codeword CW may be stored in a parity cell array, an ECC cell array, a parity chip, or the like storing parity data.

The ECC circuit 100 may perform an ECC decoding operation on the codeword CW provided from the outside (e.g., a memory or the like to detect an error in the codeword CW and correct the detected error) in a read operation. The ECC circuit 100 may output the message MSG in which an error has been corrected.

In example embodiments, the ECC encoding operation and the ECC decoding operation may correspond to Reed-Solomon (RS) encoding and RS decoding, respectively. During RS decoding, an error of a read codeword CW may be corrected in a symbol unit. As used herein, the term "symbol" is a basic unit of RS encoding and RS decoding and may be data including a certain number of bits. For example, one symbol may include a certain number of bits, such as 4, 8, or 16 bits.

In the specification, the term "symbol" is a basic unit of RS encoding and RS decoding and indicates data including a certain number of bits. For example, one symbol may include data bits, such as 8 or 16 bits.

In example embodiments, the ECC circuit 100 may include an ECC encoder 110 and an ECC decoder 120.

The ECC encoder 110 may perform RS encoding on the message MSG and output the codeword CW. In example embodiments, the ECC encoder 110 may include a cyclic redundancy check (CRC) encoder 111 and a forward error correction (FEC) encoder 112. The CRC encoder 111 may perform RS CRC-based encoding on the message MSG and output a CRC codeword CRC_CW including the message MSG and a first parity data set. The first parity data set may include a plurality of pieces of CRC parity data. The FEC encoder 112 may perform RS FEC-based encoding on the CRC codeword CRC_CW and output the codeword CW including the CRC codeword CRC_CW and a second parity data set. The second parity data set may include a plurality of pieces of CRC parity data. The codeword CW may be referred to as an FEC codeword.

The ECC decoder 120 may perform RS decoding on the codeword CW and output the message MSG. The message MSG output by the ECC decoder 120 may include error-corrected user data or error-free user data. In example embodiments, the ECC decoder 120 may include a CRC decoder 121 and an FEC decoder 122. The FEC decoder 122 may perform RS FEC-based decoding on the codeword CW and output the CRC codeword CRC_CW. The CRC decoder 121 may perform RS CRC-based decoding on the CRC codeword CRC_CW and output the message MSG.

The CRC encoder 111 and the CRC decoder 121 may be included in an RS CRC code, and the RS CRC code may be an RS code used to detect an error. The FEC encoder 112 and the FEC decoder 122 may be included in an RS FEC code, and the RS FEC code may be an RS code used to detect and correct an error.

A decoding operation in the RS CRC code may be the same as an encoding operation, and the decoding operation may be distinguished from the encoding operation according to whether input data is the message MSG (or information) or the codeword CW. Specifically, the message MSG (or information) may be input in the encoding operation, whereas the codeword CW may be input in the decoding operation.

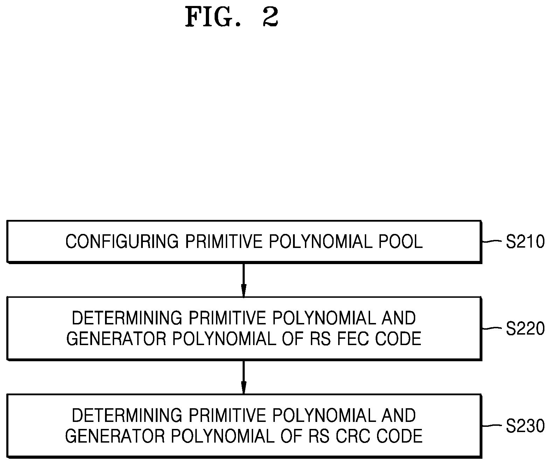

FIG. 2 is a flowchart of a method of designing an ECC circuit, according to example embodiments.

Referring to FIG. 2, the method of designing an ECC circuit may correspond to a method of designing an RS FEC code and an RS CRC code in an RS code. The RS code is an algebraic code configured to perform an operation in a nonbinary symbol unit. When a layout "$(N, K, t)$" is given, the complexity of encoding and decoding is determined according to a design scheme and is characterized by the same error correction capability. In the layout "$(N, K, t)$", $N$ denotes the length of a codeword (or the number of symbols constituting the codeword). In the layout "$(N, K, t)$", $K$ denotes the length of information (or the number of symbols constituting the information) or the length of user data. In the layout "$(N, K, t)$", $t$ denotes the number of correctable symbols or a capability indicating how many symbols are error-correctable. In the layout "$(N, K, t)$", it is always satisfied that $2t = N - K$. If the size of a Galois field (GF) dealt with in a corresponding RS code is $2^m$, it is satisfied that $N \leq 2^m - 1$. When a layout "$(N_{FEC}, K_{FEC}, t_{FEC})$" of an RS FEC code and a layout "$(N_{crc}, K_{crc}, t_{crc})$" of an RS CRC code, which are defined in a GF $GF(2^m)$, are given, because an output (e.g., the CRC codeword CRC_CW) of the RS CRC code is an input of the RS FEC code, $K_{FEC} = N_{crc}$. In a GF $GF_1(2^m)$ of the RS FEC code, an m-th order primitive polynomial $p_1(x)$ and a 2t-th order generator polynomial $g_1(x)$ are defined, and in a GF $GF_2(2^m)$ of the RS CRC code, an m-th order primitive polynomial $p_2(x)$ and a 2t-th order generator polynomial $g_2(x)$ are defined. Therefore, the RS FEC code and the RS CRC code may be designed by determining respective primitive polynomials and respective generator polynomials. Determination of a primitive polynomial includes determining a system of the four fundamental arithmetic operations between symbols in a GF and influences the complexity of the four fundamental arithmetic operations between the symbols. Determination of a generator polynomial includes determining an encoding/decoding algorithm of the RS code and a complexity according to encoding/decoding in the system of the four fundamental arithmetic operations determined by a given primitive polynomial. Encoding/decoding algorithm calculation of the RS CRC code is similar to encoding/decoding algorithm calculation of the RS FEC code, and the RS FEC code is designed by considering not only an encoder calculation operation but also a decoder calculation operation, and thus, an RS FEC code design condition is more complicated than an RS CRC code design condition. In addition, when the same primitive polynomial is applied to the RS FEC code and the RS CRC code, an undetected error probability (UEP) may be high.

In the GF $GF(2^m)$, an m-th order primitive polynomial may be represented by [Equation 1] below.

[Equation 1]

$$p(x) = \sum_{i=0}^{m} x^i$$

In the GF GF($2^m$), a generator polynomial may be represented by [Equation 2] below.

[Equation 2]

$$g(x) = \prod_{i=0}^{2t-1} (x - \alpha^{b+i})$$

Herein, $t$ denotes a parameter included in the layout *"(N, K, t)"* of the RS code as described above. In addition, b may be determined by various values from 0 to $2^m$ - 2, but to reduce multiplications during syndrome calculation in a decoding operation and reduce an additional calculation complexity when a Forney algorithm is performed, the value of $b$ for determining a generator polynomial may be set to 0 or 1. Preferably, the value of b may be set to 0. In example embodiments, it is assumed that the value of b is 0.

In operation S210, a primitive polynomial pool is configured. The primitive polynomial pool may include a plurality of primitive polynomials. Each primitive polynomial may be a polynomial having a leading term m on a GF GF($2^m$). Herein, m may be an integer.

In operation S220, a primitive polynomial and a generator polynomial of an RS FEC code are determined. The primitive polynomial of the RS FEC code may be referred to as a first primitive polynomial, and the generator polynomial of the RS FEC code may be referred to as a first generator polynomial.

In operation S230, a primitive polynomial and a generator polynomial of an RS CRC code are determined. The primitive polynomial of the RS CRC code may be referred to as a second primitive polynomial, and the generator polynomial of the RS CRC code may be referred to as a second generator polynomial.

In example embodiments, the method of designing an ECC circuit has an optimal FEC error correction capability and CRC error correction capability, and enables efficient hardware design and low-complexity encoding/decoding, thereby reducing a manufacturing complexity. In addition, the power efficiency of a product may be improved.

In example embodiments, the RS FEC code and the RS CRC code may be used for next-generation peripheral component interconnect express (PCIe), universal flash storage (UFS), and the like.

Hereinafter, example embodiments, in which a primitive polynomial and a generator polynomial of each of the RS FEC code and the RS CRC code are determined, are described below.

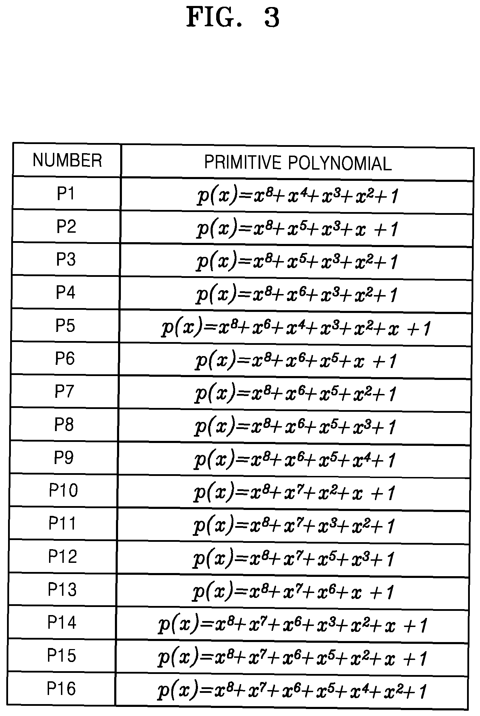

FIG. 3 illustrates a table including a primitive polynomial pool according to example embodiments.

Referring to FIG. 3, the primitive polynomial pool may include primitive polynomials, in which the complexity of a multiplication between two symbols is less than or equal to a reference value, among all m-th order primitive polynomials existing with respect to a layout *"(N, K, t)"* of a given RS code on a GF *GF($2^m$)*. The primitive polynomial pool may be represented by [Equation 3] below.

[Equation 3]

$$\mathbb{P}^* = \{p(x) \in \mathbb{P} | L_{p(x)} \leq L_{th}\}$$

Herein, $L_{p(x)}$ denotes a logic gate count necessary for a multiplication between two arbitrary symbols with respect to a primitive polynomial $p(x)$, and $L_{th}$ denotes the reference value (or the threshold value) of the logic gate count. The logic gate count may correspond to the complexity of a multiplication and correspond to the total number of exclusive ORs (XORs) necessary to calculate the coefficients of a code polynomial. A code polynomial of a codeword having a length of N may be represented by [Equation 4] below.

[Equation 4]

$$c(x) = \sum_{i=0}^{N-1} c_i x^i$$

Herein, N denotes the length of the codeword CW and a parameter included in the layout *"(N, K, t)"* of the RS code as described above.

For example, with reference to FIG. 3, it is assumed that m is 8 and a layout "(255, 249, 3)" of an RS FEC code and a layout "(249, 241, 4)" of an RS CRC code, which are defined in a GF $GF(2^8)$, are given. The total number of primitive polynomials, in which the complexity of a multiplication between two symbols in the GF $GF(2^8)$ may be 16, and 16 primitive polynomials P1 to P16 are shown in FIG. 3. However, example embodiments are not limited thereto.

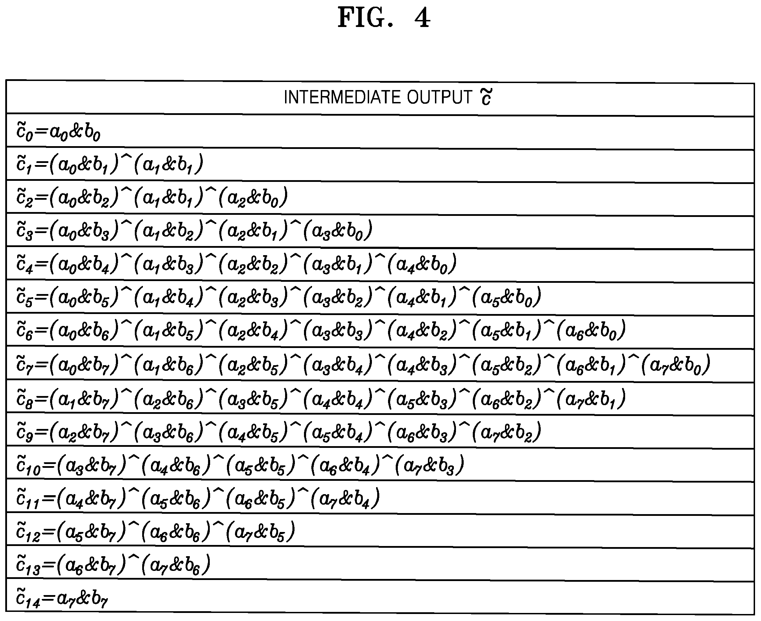

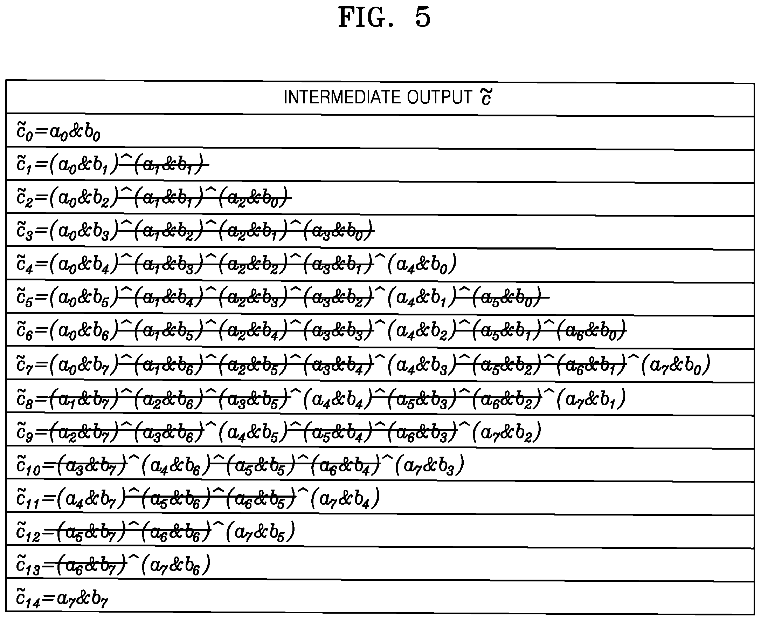

FIGS. 4 and 5 illustrate tables including intermediate results in a multiplication operation between symbols, according to example embodiments.

Referring to FIGS. 3 and 4, a multiplication operation between two symbols in the GF $GF(2^8)$ defined by an arbitrary primitive polynomial $p(x)$ may be represented by a binary representation, such as [Equation 5] below. The size of the GF $GF(2^8)$ described above is illustrative.

[Equation 5]
$$a \times b \rightarrow \underbrace{\underbrace{(a_0 + a_1 x + a_2 x^2 + \cdots + a_7 x^7)(b_0 + b_1 x + b_2 x^2 + \cdots + b_7 x^7)}_{\tilde{c}} \bmod p(x)}_{c}$$

Herein, $a$ and $b$ are two arbitrary symbols, mod denotes a modulo operation on a primitive polynomial $p(x)$ on the GF $GF(2^8)$, and $\tilde{c}$ may be an intermediate result in the multiplication operation. For example, $\tilde{c}$ may be a coefficient according to a multiplication between two symbols. In addition, c may be a coefficient of a code polynomial c(x).

In FIG. 4, intermediate results $\tilde{c}_0$ to $\tilde{c}_{14}$ in the multiplication operation may be the coefficients of a $0^{th}$-order term to a $14^{th}$-order term, respectively. In FIG. 4, a symbol "&" indicates multiplication. In FIG. 4, a symbol "^" indicates addition, and the addition may indicate XOR. The intermediate results $\tilde{c}_0$ to $\tilde{c}_{14}$ in the multiplication operation may be calculated by the same calculation operation regardless of a primitive polynomial.

If any one of two symbols is specified, when the intermediate results $\tilde{c}_0$ to $\tilde{c}_{14}$ in the multiplication operation are calculated, the logic gate count and a calculation complexity may be reduced. For example, with reference to FIG. 5, when one symbol $a$ is 145 ($[a_7, a_6, a_5, a_4, a_3, a_2, a_1, a_0]=[1, 0, 0, 0, 1, 0, 0, 1]$), as shown in FIG. 5, a formula including "$a_1$", "$a_2$", "$a_4$", "$a_5$", or "$a_6$" may be omitted. Therefore, a formula for calculating the intermediate results $\tilde{c}_0$ to $\tilde{c}_{14}$ in the multiplication operation may be simplified.

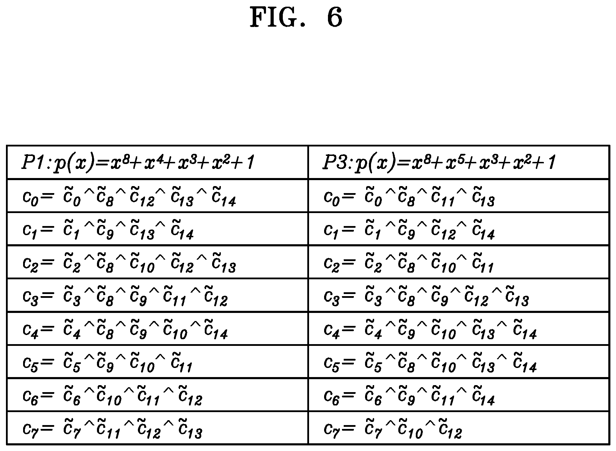

FIG. 6 illustrates a table including coefficients of a code polynomial with respect to each of example primitive polynomials, according to example embodiments.

Referring to FIGS. 3, 4, and 6, in the multiplication operation $\tilde{c} \bmod p(x)$ according to [Equation 5] described above, the result of the modular operation may vary according to a primitive polynomial, and accordingly, the complexity of a multiplication may also vary according to the primitive polynomial.

For example, with reference to FIGS. 3 and 6, it is assumed that the layout "(255, 249, 3)" of the RS FEC code and the layout "(249, 241, 4)" of the RS CRC code, which are defined in the GF $GF(2^8)$, are given. It is assumed that the coefficients of a code polynomial are calculated based on a primitive polynomial P1 and a primitive polynomial P3.

The primitive polynomial P1 of FIG. 3 may be represented by [Equation 6] below.

[Equation 6]
$$p(x) = x^8 + x^4 + x^3 + x^2 + 1$$

Accordingly, each of coefficients $c_0$ to $c_7$ of a code polynomial with respect to the primitive polynomial P1 may be configured by additions (e.g., XORs) between the intermediate results $\tilde{c}_0$ to $\tilde{c}_{14}$ in the multiplication operation, as shown in FIG. 6. For example, the coefficient $c_0$ of the $0^{th}$-order term (or the constant term) in the code polynomial with respect to the primitive polynomial P1 may be configured by XORs of intermediate results $\tilde{c}_0$, $\tilde{c}_8$, $\tilde{c}_{12}$, $\tilde{c}_{13}$, and $\tilde{c}_{14}$ in the multiplication operation. For example, the coefficient $c_1$ of the first-order term in the code polynomial with respect to the primitive polynomial P1 may be configured by XORs of intermediate results $\tilde{c}_1$, $\tilde{c}_9$, $\tilde{c}_{13}$, and $\tilde{c}_{14}$ in the multiplication operation. The coefficients $c_2$ to $c_7$ of the second-order term to the seventh-order term in the code polynomial with respect to the primitive polynomial P1 may be the same as shown in FIG. 6.

The multiplication complexity of the primitive polynomial P1 may be obtained based on a logic gate count, and the logic gate count may be obtained by counting the total number of XORs (e.g., XOR operations) necessary to calculate the coefficients $c_0$ to $c_7$ of the code polynomial with respect to the primitive polynomial P1. For example, with reference to FIG. 6, the number of XORs necessary to calculate the coefficient $c_0$ with respect to the primitive polynomial P1 is 4, and the number of XORs necessary to calculate the coefficient $c_1$ with respect to the primitive polynomial P1 is 3. Likewise, the numbers of XORs necessary to calculate the coefficients $c_2$ to $c_7$ of the second-order term to the seventh-order term in the code polynomial with respect to the primitive polynomial P1 is 4, 4, 4, 3, 3, and 3, respectively. Therefore, the multiplication complexity of the primitive polynomial P1 is 28 (4+3+4+4+4+3+3+3).

In addition, a depth may be used to determine a latency. The depth of the primitive polynomial P1 may be obtained by counting the maximum number of intermediate results in a multiplication operation necessary to calculate one coefficient. For example, with reference to FIG. 6, for the $0^{th}$-order term (the constant term) and the second-order term to the fourth-order term in the code polynomial with respect to the primitive polynomial P1, the number of intermediate results necessary to calculate a coefficient is 5, and thus, the depth of the primitive polynomial P1 is 5.

The primitive polynomial P3 of FIG. 3 may be represented by [Equation 7] below.

[Equation 7]

$$p(x) = x^8 + x^5 + x^3 + x^2 + 1$$

Accordingly, each of coefficients $c_0$ to $c_7$ of a code polynomial with respect to the primitive polynomial P3 may be configured by additions (e.g., XORs) between the intermediate results $\tilde{c}_0$ to $\tilde{c}_{14}$ in the multiplication operation, as shown in FIG. 6.

The multiplication complexity of the primitive polynomial P3 may be obtained by counting the total number of XORs (e.g., XOR operations) necessary to calculate the coefficients $c_0$ to $c_7$ of the code polynomial with respect to the primitive polynomial P3. For example, with reference to FIG. 6, the numbers of XORs necessary to calculate the coefficients $c_0$ to $c_7$ of the $0^{th}$-order term to the seventh-order term in the code polynomial with respect to the primitive polynomial P3 is 3, 3, 3, 4, 4, 4, 3 and 2, respectively. Therefore, the multiplication complexity of the primitive polynomial P3 is 26 (3+3+3+4+4+4+3+2).

In addition, the depth of the primitive polynomial P3 is 5 because the number of intermediate results necessary to calculate the coefficient of each of the third-order term to the fifth-order term in the code polynomial with respect to the primitive polynomial P3 is 5 with reference to FIG. 6.

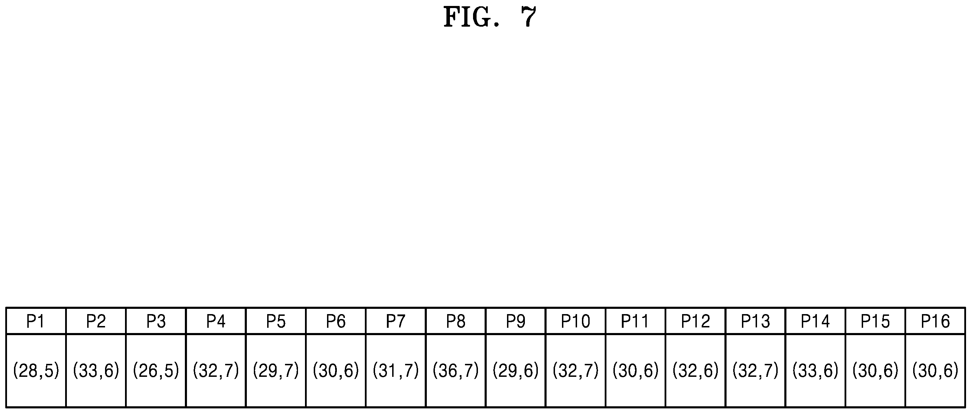

FIG. 7 illustrates a table including the complexity and the depth of a multiplication in a primitive polynomial pool, according to example embodiments.

Referring to FIGS. 3, 6, and 7, it is assumed as described above that the layout "(255, 249, 3)" of the RS FEC code and the layout "(249, 241, 4)" of the RS CRC code, which are defined in the GF $GF(2^8)$, are given. In this case, the complexity (e.g., the logic gate count) and the depth of a multiplication for each primitive polynomial in the primitive polynomial pool may be calculated as shown in FIG. 7. In example embodiments, a primitive polynomial having the least multiplication complexity and a primitive polynomial having the second least multiplication complexity may be determined as candidates of an RS code.

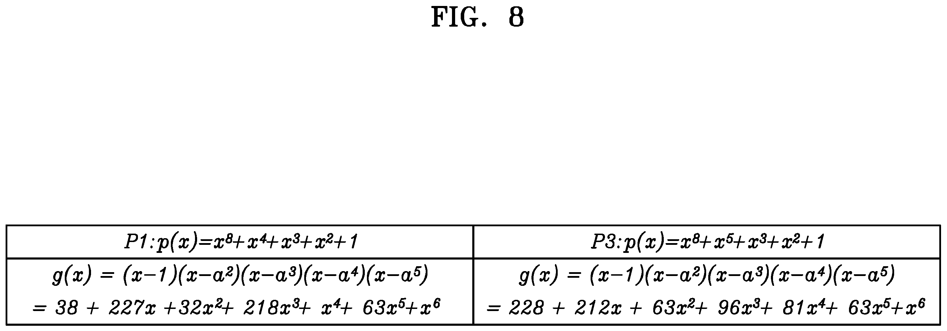

FIG. 8 illustrates a generator polynomial with respect to each of example primitive polynomials, according to example embodiments.

Referring to FIGS. 3, 7, and 8, in example embodiments, a primitive polynomial having the least multiplication complexity and a primitive polynomial having the second least multiplication complexity in the primitive polynomial pool configured as described above may be determined as candidates of a first primitive polynomial $p_1(x)$ of the RS FEC code, and then a first generator polynomial $g_1(x)$ with respect to the first primitive polynomial $p_1(x)$ may be determined. The first generator polynomial $g_1(x)$ may be represented by [Equation 8] that is similar to [Equation 2] described above.

[Equation 8]

$$g_1(x) = \prod_{i=0}^{2t_{FEC}-1} (x - \alpha^{b_1+i})$$

Herein, $t_{FEC}$ denotes a parameter included in the layout "($N_{FEC}$, $K_{FEC}$, $t_{FEC}$)" of the RS FEC code as described above, and $b_1$ may be determined as various values like b in [Equation 2] described above but is assumed to be 0. When $b_1$ is 0, an additional calculation complexity may decrease when the Forney algorithm is performed in a decoding operation.

The RS FEC code may be designed by solidarity consideration of the first primitive polynomial $p_1(x)$ and the first generator polynomial $g_1(x)$. Solidarity consideration of polynomials may include, for example, considering a syndrome operation in a decoding operation in the RS FEC code.

The number of syndromes may be $2t$ (as described above, $t$ denotes the number of correctable symbols or a capability about how many symbols are error-correctable), and the length of one syndrome may be the same as the length of the codeword CW. A syndrome operation includes calculating one syndrome by substituting each of roots $\alpha^{b1}$, $\alpha^{b1+1}$.., $\alpha^{b1+2t-1}$ of the first generator polynomial $g_1(x)$ into the codeword CW (e.g., a code polynomial c(x) corresponding to the codeword CW), and an arbitrary syndrome may be represented by [Equation 9] below.

[Equation 9]

$$S_j = \sum_{i=0}^{N-1} c_i (\alpha^{b_1+j})^i \text{ for } j = 0, 1, \ldots, 2t-1$$

Herein, N denotes the length of the codeword CW, a code polynomial corresponding to the codeword CW is $c(x) = c_0 + c_1 x + \cdots + c_{N-1} x^{N-1}$, and $c_i$ may be the value of an $i$th location in the codeword CW. In [Equation 9], when $\alpha^0$ is included as a root of the first generator polynomial $g_1(x)$, multiplications between symbols during a syndrome operation may be removed, thereby reducing a calculation complexity. When $b_1$ for determining the first generator polynomial $g_1(x)$ is 0, as described above, multiplications during a syndrome operation in a decoding operation may be reduced, and an additional calculation complexity in the Forney algorithm may be reduced. A symbol exponent-based representation of the first generator polynomial $g_1(x)$ does not vary, but a binary representation corresponding to each symbol varies according to a primitive polynomial, and thus, an encoding complexity based on the first generator polynomial $g_1(x)$ may also vary according to the primitive polynomial. Therefore, the RS FEC code may be determined by solidarity consideration of the complexity of multiplications and the implementation complexity of the first generator polynomial $g_1(x)$ according to a primitive polynomial in the primitive polynomial pool.

When the RS FEC code is implemented based on a linear feedback shift register (LFSR) of generator polynomials including the root $\alpha^0$ with respect to primitive polynomials selected according to the process described above, a generator polynomial may be determined based on an implementation complexity, and accordingly, a primitive polynomial may also be determined. For example, with reference to FIG. 8, it is assumed that the layout "(255, 249, 3)" of the RS FEC code and the layout "(249, 241, 4)" of the RS CRC code, which are defined in the GF $GF(2^8)$, are given.

A generator polynomial with respect to the primitive polynomial P1 may be represented by [Equation 10].

[Equation 10]

$$g(x) = (x-1)(x-\alpha)(x-\alpha^2)(x-\alpha^3)(x-\alpha^4)(x-\alpha^5)$$
$$= 38 + 227x + 32x^2 + 218x^3 + x^4 + 63x^5 + x^6$$

A generator polynomial with respect to the primitive polynomial P3 may be represented by [Equation 11].

[Equation 11]

$$g(x) = (x-1)(x-\alpha)(x-\alpha^2)(x-\alpha^3)(x-\alpha^4)(x-\alpha^5)$$
$$= 228 + 212x + 63x^2 + 96x^3 + 81x^4 + 63x^5 + x^6$$

The primitive polynomial P1 includes more 1s as the coefficients of a generator polynomial than the primitive polynomial P3. A generator polynomial that has a coefficient of 1 has a low calculation complexity. Thus, when a dedicated multiplier for each coefficient is configured, a calculation complexity may be further lowered. Therefore, the first primitive polynomial $p_1(x)$ of the RS FEC code may be determined as the primitive polynomial P1, and then the first generator polynomial $g_1(x)$ with respect to the first primitive polynomial $p_1(x)$ may be determined as a polynomial, such as [Equation 10].

When the first primitive polynomial $p_1(x)$ of the RS FEC code is determined as the primitive polynomial P1, a primitive polynomial having the least multiplication calculation complexity (e.g., a multiplication complexity or a required logic gate count), among primitive polynomials remaining by excluding the primitive polynomial P1 selected as the first primitive polynomial $p_1(x)$ from the primitive polynomial pool, may be selected as a second primitive polynomial $p_2(x)$ of the RS CRC code. The second primitive polynomial $p_2(x)$ may be represented by [Equation 12] below.

[Equation 12]

$$p_2(x) = \text{argmin}_{p(x) \in \mathbb{P}^* \backslash \{p_1(x)\}} L_{p(x)}$$

The primitive polynomial P1 selected as the first primitive polynomial $p_1(x)$ of the RS FEC code is excluded from the second primitive polynomial $p_2(x)$ of the RS CRC code because errors undetected from the RS FEC code may not be detected even from the RS CRC code when a primitive polynomial of the RS FEC code is the same as a primitive polynomial of the RS CRC code. For example, the second primitive polynomial $p_2(x)$ of the RS CRC code may be determined as the primitive polynomial P3.

When the second primitive polynomial $p_2(x)$ of the RS CRC code is determined, a generator polynomial having the least required logic gate count may be determined as a second generator polynomial $g_2(x)$. The second generator polynomial $g_2(x)$ may be represented by [Equation 13] below.

[Equation 13]

$$g_2(x) = (x - \alpha^{b_2})(x - \alpha^{b_2+1}) \dots (x - \alpha^{b_2+2t_{crc}-1}) \text{ where } b_2 = 2^{m-1} - t_{crc}$$

Herein, $t_{crc}$ denotes a parameter included in the layout "$(N_{crc}, K_{crc}, t_{crc})$" of the RS CRC code, and $b_2$ may be determined as various values from 0 to $2^m$ - 2, like $b_1$ described above, and set by $b_2 = 2^{m-1}$ - $t_{crc}$. Unlike RS FEC, because encoding is very similar to decoding in an RS CRC operation, $b_2$ may be set such that a calculation complexity is optimized when a generator polynomial is implemented and the RS CRC operation is optimized when a logic is implemented. A case where $b_2$ is set to $2^{m-1}$ - $t_{crc}$ may be most suitable for optimization of the RS CRC design described above.

When the second generator polynomial $g_2(x)$ with respect to the second primitive polynomial $p_2(x)$ and $t_{crc}$ of the given RS CRC code is determined as [Equation 13] described above, the second generator polynomial $g_2(x)$ is characterized by [Equation 14] below.

[Equation 14]

$$g_s^2 = g_{2t_{crc}-s}^2 \text{ where } g_2(x) = \sum_{i=0}^{2t_{crc}} g_i^2 x^i$$

Herein, $s$ may be an integer of 0 to $t_{crc}$ - 1 inclusive. According to [Equation 14], coefficients $g_s^2$ and $g_{2t_{crc}-s}^2$ are always mirror-symmetrical based on a $t_{crc}$ th-order term. In addition, according to [Equation 14], the coefficient of a $0^{th}$-order term (a constant term) $x^0$ is the same as the coefficient of the leading term $x^{2t_{crc}}$, and the values of the coefficients may be 1. According to [Equation 14], one multiplier is removed when the RS CRC code is encoded/decoded. In addition, multiplications related to terms having the same coefficient are implemented at one time, thereby reducing a logic gate count and a multiplication complexity.

For example, it is assumed that the layout "(255, 249, 3)" of the RS FEC code and the layout "(249, 241, 4)" of the RS CRC code, which are defined in the GF $GF(2^8)$, are given. When the first primitive polynomial $p_1(x)$ of the RS FEC code is determined as the primitive polynomial P1, the second primitive polynomial $p_2(x)$ of the given RS CRC code may be determined as the primitive polynomial P3. In this case, the second generator polynomial $g_2(x)$ of the given RS CRC code may be the same as [Equation 15] below.

[Equation 15]
$$g_2(x) = 1 + 235x + 164x^2 + 48x^3 + 25x^4 + 48x^5 + 164x^6 + 235x^7 + x^8$$

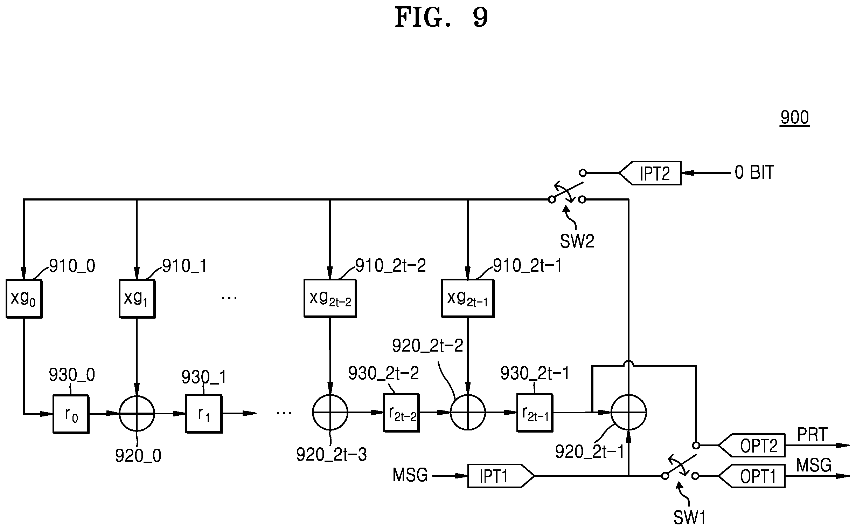

FIG. 9 is a block diagram of an FEC encoder 900 according to example embodiments.

Referring to FIG. 9, the FEC encoder 900 may be designed as described above with reference to FIGS. 2 to 8. In example embodiments, the FEC encoder 900 may include a first switch SW1 (e.g., a transistor), a second switch SW2, a plurality of multiplication circuits 910_0, 910_1, ..., 910_2t-1, a plurality of addition circuits 920_0, 920_1, ..., 920_2t-1, and a plurality of registers 930_0, 930_1, ..., 930_2t-1. When the layout "(N, K, t)" of the RS FEC code is given, the FEC encoder 900 may include $2t$ multiplication circuits, $2t$ addition circuits, and $2t$ registers. The first switch SW1 is connected to a first input end IPT1 and the addition circuit 920_2t-1, and the first switch SW1 may be connected to a first output end OPT1 or a second output end OPT2. The second switch SW2 is connected to the plurality of multiplication circuits 910_0, 910_1, ..., 910_2t-1, and the second switch SW2 may be connected to the addition circuit 920_2t-1 or a second input end IPT2.

The message MSG may be input to the first input end IPT1 of the FEC encoder 900. For example, the coefficients of a polynomial corresponding to the message MSG may be input to the first input end IPT1. The first switch SW1 may be connected to the first output end OPT1, and the second switch SW2 may be connected to the addition circuit 920_2t-1. The first and second switches SW1 and SW2 may be controlled by a controller configured to control the FEC encoder 900. The message MSG may be output through the first output end OPT1, input to the addition circuit 920_2t-1, and input to each of the plurality of multiplication circuits 910_0, 910_1, ..., 910_2t-1.

After the message MSG is output through the first output end OPT1, the first switch SW1 may be connected to the second output end OPT2. The second switch SW2 is connected to the addition circuit 920_2t-1. The plurality of multiplication circuits 910_0, 910_1, ..., 910_2t-1 may multiply the message MSG by coefficients $g_0$ to $g_{2t-1}$ of the first generator polynomial $g_1(x)$. For example, the multiplication circuit 910_0 may multiply the coefficients of a polynomial corresponding to the message MSG by the coefficient $g_0$ of the first generator polynomial $g_1(x)$ and provide the result value of the multiplication to the register 930_0. The multiplication circuit 910_1 may multiply the coefficients of the polynomial corresponding to the message MSG by the coefficient $g_1$ of the first generator polynomial $g_1(x)$ and provide the result value of the multiplication to the addition circuit 920_0. Likewise, the multiplication circuit 910_2t-2 may multiply the coefficients of the polynomial corresponding to the message MSG by the coefficient $g_{2t-2}$ of the first generator polynomial $g_1(x)$ and provide the result value of the multiplication to the addition circuit 920_2t-3. The multiplication circuit 910_2t-1 may multiply the coefficients of the polynomial corresponding to the message MSG by the coefficient $g_{2t-1}$ of the first generator polynomial $g_1(x)$ and provide the result value of the multiplication to the addition circuit 920_2t-2.

In example embodiments, when the first generator polynomial $g_1(x)$ is the same as [Equation 10] described above with reference to FIG. 8, the coefficients $g_0$ to $g_6$ of the first generator polynomial $g_1(x)$ may be 38, 227, 32, 218, 1, 63, and 1.

The plurality of addition circuits 920_0, 920_1, ..., 920_2t-1 may add the result values of the multiplications of the plurality of multiplication circuits 910_0, 910_1, ..., 910_2t-1 and values stored in the plurality of registers 930_0, 930_1, ..., 930_2t-1. An addition may be an XOR operation. For example, the addition circuit 920_0 may perform an XOR operation on the result value of the multiplication of the multiplication circuit 910_0 and a value stored in the register 930_0, and provide the result value of the addition to the register 930_1. Likewise, the other addition circuits may perform the same operation as described above. The plurality of registers 930_0, 930_1, ..., 930_2t-1 may output the values stored therein. By sequentially storing, in a subsequent register, a value stored in a previous register, a value stored in the register 930_2t-1 may be sequentially output as parity data PRT through the second output end OPT2.

The first switch SW1 may be connected to the first output end OPT1, and the second switch SW2 may be connected to the second input end IPT2. A zero bit value 0 BIT may be input to the second input end IPT2.

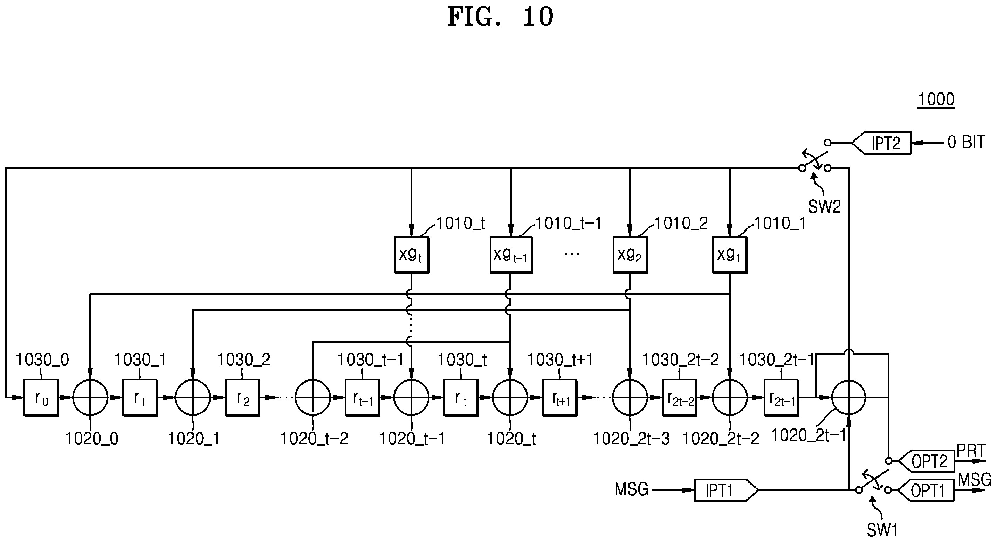

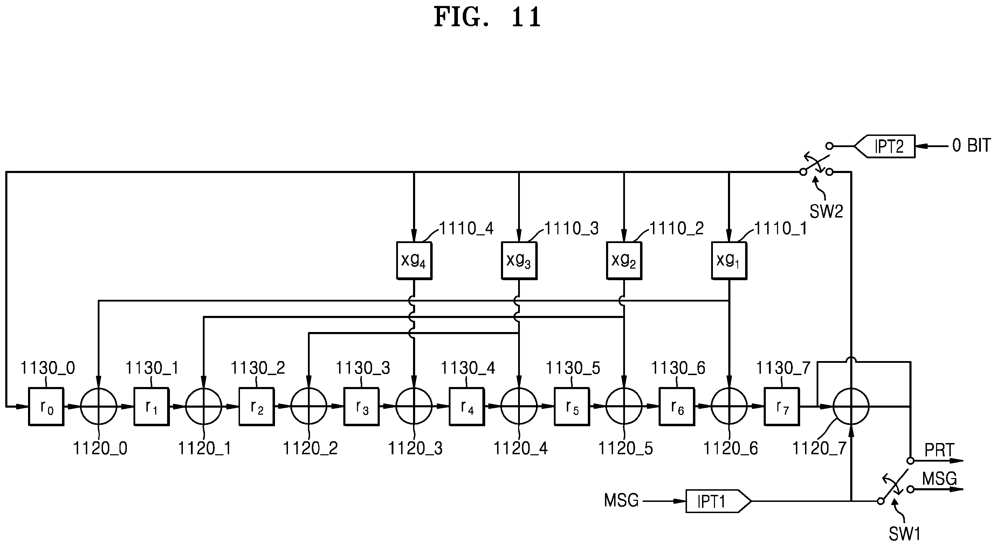

FIGS. 10 and 11 are block diagrams of a CRC encoder 1000 according to example embodiments.

Referring to FIG. 10, the CRC encoder 1000 may be designed as described above with reference to FIGS. 2 to 8. In example embodiments, the CRC encoder 1000 may include the first switch SW1, the second switch SW2, a plurality of multiplication circuits 1010_1, 1010_2, ..., 1010_t, a plurality of addition circuits 1020_0, 1020_1, ..., 1020_2t-1, and a plurality of registers 1030_0, 1030_1, ..., 1030_2t-1. When the layout *"(N, K, t)"* of the RS CRC code is given, the CRC encoder 1000 may include *2t* addition circuits and *2t* registers. The description made above with reference to FIG. 9 is omitted from descriptions to be made for each of the plurality of multiplication circuits 1010_1, 1010_2, ..., 1010_t, the plurality of addition circuits 1020_0, 1020_1, ..., 1020_2t-1, and the plurality of registers 1030_0, 1030_1, ..., 1030_2t-1 shown in FIG. 10.

In example embodiments, according to [Equation 14] described above with reference to FIG. 8, coefficients $g_s^2$ and $g_{2t-s}^2$ (*s* is an integer of 0 to *t* - 1 inclusive) are mirror-symmetrical based on a tth-order term in the second generator polynomial $g_2(x)$, and the coefficient of the $0^{th}$-order term (the constant term) $x^0$ and the coefficient of the leading term $x^{2t}$ are 1, and thus, the number of multiplication circuits may be *t*.

The coefficients of a polynomial corresponding to the message MSG may be stored in the register 1030_0 and provided to each of the plurality of multiplication circuits 1010_1, 1010_2, ..., 1010_t. The multiplication circuit 1010_1 may multiply the coefficients of the polynomial corresponding to the message MSG by the coefficient $g_1$ of the second generator polynomial $g_2(x)$ and provide the result value of the multiplication to the addition circuits 1020_0 and 1020_2t-2. The multiplication circuit 1010_2 may multiply the coefficients of the polynomial corresponding to the message MSG by the coefficient $g_2$ of the second generator polynomial $g_2(x)$ and provide the result value of the multiplication to the addition circuits 1020_1 and 1020_2t-3. Likewise, the multiplication circuit 1010_t-1 may multiply the coefficients of the polynomial corresponding to the message MSG by the coefficient $g_{t-1}$ of the second generator polynomial $g_2(x)$ and provide the result value of the multiplication to the addition circuits 1020_t-2 and 1020_t. The multiplication circuit 1010_t may multiply the coefficients of the polynomial corresponding to the message MSG by the coefficient $g_t$ of the second generator polynomial $g_2(x)$ and provide the result value of the multiplication to the addition circuit 1020_t-1.

Referring to FIG. 11, the first switch SW1, the second switch SW2, four multiplication circuits 1110_1, 1110_2, 1110_3, 1110_4, eight addition circuits 1120_0 to 1120_7, and eight registers 1130_0 to 1130_7 may be one example of the CRC encoder 1000 of FIG. 10. In example embodiments, when the first generator polynomial $g_1(x)$ is the same as [Equation 10] described above and the second generator polynomial $g_2(x)$ is the same as [Equation 15] described above, the coefficients $g_1$ to $g_4$ of the second generator polynomial $g_2(x)$ may be 235, 164, 48, and 25, and the coefficients $g_0$ and $g_6$ of the second generator polynomial $g_2(x)$ may be 1.

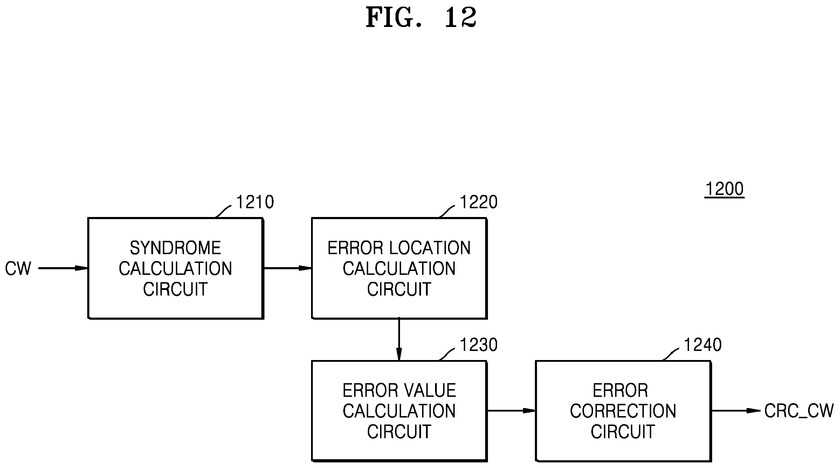

FIG. 12 is a block diagram of an FEC decoder 1200 according to example embodiments.

Referring to FIG. 12, the FEC decoder 1200 may be designed as described above with reference to FIGS. 2 to 8. In example embodiments, the FEC decoder 1200 may include a syndrome calculation circuit 1210, an error location calculation circuit 1220, an error value calculation circuit 1230, and an error correction circuit 1240.

The syndrome calculation circuit 1210 may calculate one or more syndromes based on the codeword CW and the first generator polynomial $g_1(x)$. The coefficients of the first generator polynomial $g_1(x)$ are the same as described above with reference to FIG. 9.

The error location calculation circuit 1220 may calculate the coefficients of an error location polynomial based on the one or more syndromes and calculate an error location based on a determined error location polynomial. For example, the error location calculation circuit 1220 may calculate the error location polynomial and the coefficients of the error location polynomial based on an algorithm, such as a Berlekamp-Massey algorithm or a Euclid algorithm, and the one or more syndromes. The error location calculation circuit 1220 may calculate the error location in the error location polynomial by using a Chien search algorithm.

The error value calculation circuit 1230 may calculate an error value based on the calculated error location. For example, the error value calculation circuit 1230 may calculate an error value polynomial by using an algorithm, such as the Euclid algorithm, and calculate the error value in the error value polynomial, based on the Forney algorithm.

The error correction circuit 1240 may correct an error of the codeword CW based on the calculated error value. For example, the error correction circuit 1240 may correct the error by adding the calculated error value and the codeword CW (e.g., the coefficients of a code polynomial corresponding to the codeword CW). The error correction circuit 1240 may output the CRC codeword CRC_CW corresponding to the codeword CW of which the error has been corrected.

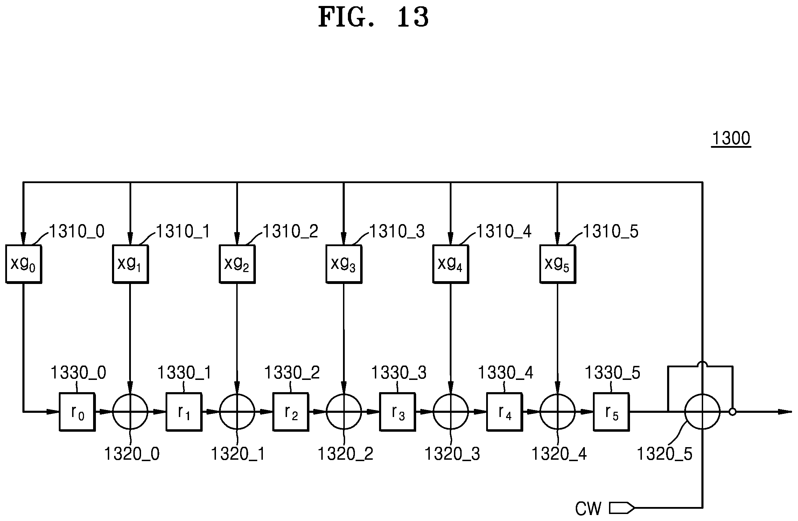

FIG. 13 is a block diagram of a syndrome calculation circuit 1300 according to example embodiments.

Referring to FIG. 13, the syndrome calculation circuit 1300 may include a plurality of multiplication circuits 1310_0 to 1310_5, a plurality of addition circuits 1320_0 to 1320_5, and a plurality of registers 1330_0 to 1330_5. As described above, when the layout "(255, 249, 3)" of the RS FEC code defined in the GF $GF(2^8)$ is given, the syndrome calculation circuit 1300 may include 6 (i.e., $2t$) multiplication circuits, 6 (i.e., $2t$) addition circuits, and 6 (i.e., $2t$) registers. For example, the coefficients $g_0$ to $g_6$ of the first generator polynomial $g_1(x)$ may be 38, 227, 32, 218, 1, 63, and 1. An input of the syndrome calculation circuit 1300 may be the codeword CW. An operation of the syndrome calculation circuit 1300 may be similar to an operation of the FEC encoder 900.

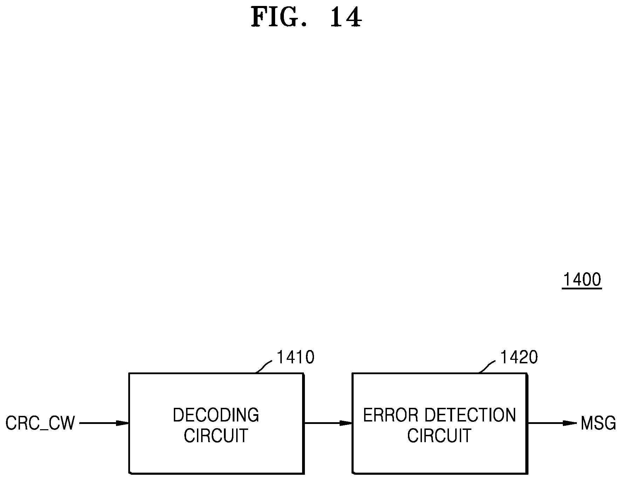

FIG. 14 is a block diagram of a CRC decoder 1400 according to example embodiments.

Referring to FIG. 14, the CRC decoder 1400 may be designed as described above with reference to FIGS. 2 to 8. In example embodiments, the CRC decoder 1400 may include a decoding circuit 1410 and an error detection circuit 1420.

The decoding circuit 1410 may calculate a first parity data set including CRC parity data, based on the CRC codeword CRC_CW and the second generator polynomial $g_2(x)$. The coefficients of the second generator polynomial $g_2(x)$ are the same as described above with reference to FIG. 10.

The error detection circuit 1420 may detect an error of the message MSG based on the first parity data set calculated by the decoding circuit 1410.

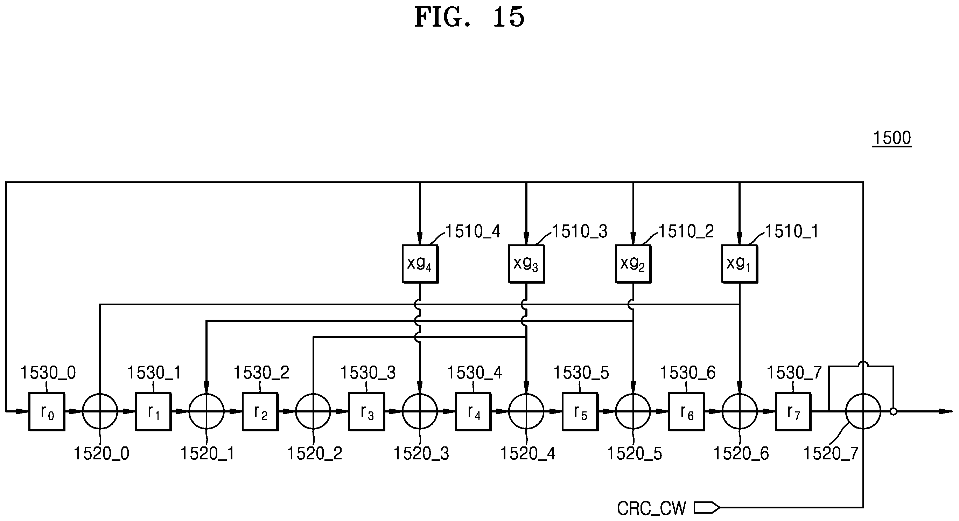

FIG. 15 is a block diagram of a decoding circuit 1500 according to example embodiments.

Referring to FIG. 15, the decoding circuit 1500 may be designed as described above with reference to FIGS. 2 to 8. In example embodiments, the decoding circuit 1500 may include the same number (e.g., $t$) of multiplication circuits, e.g., multiplication circuits 1510_0 to 1510_4, as described above with reference to FIG. 10, addition circuits 1520_0 to 1520_7, and registers 1530_0 to 1530_7. For example, with reference to FIGS. 11 and 15, it is assumed that the layout "(255, 249, 3)" of the RS FEC code and the layout "(249, 241, 4)" of the RS CRC code, which are defined in the GF $GF(2^8)$, are given. In the decoding circuit 1500, when the first generator polynomial $g_1(x)$ is the same as [Equation 10] described above and the second generator polynomial $g_2(x)$ is the same as [Equation 15] described above as shown in FIG. 11, the coefficients $g_1$ to $g_4$ of the second generator polynomial $g_2(x)$ may be 235, 164, 48, and 25, and the coefficients $g_0$ and $g_6$ of the second generator polynomial $g_2(x)$ may be 1.

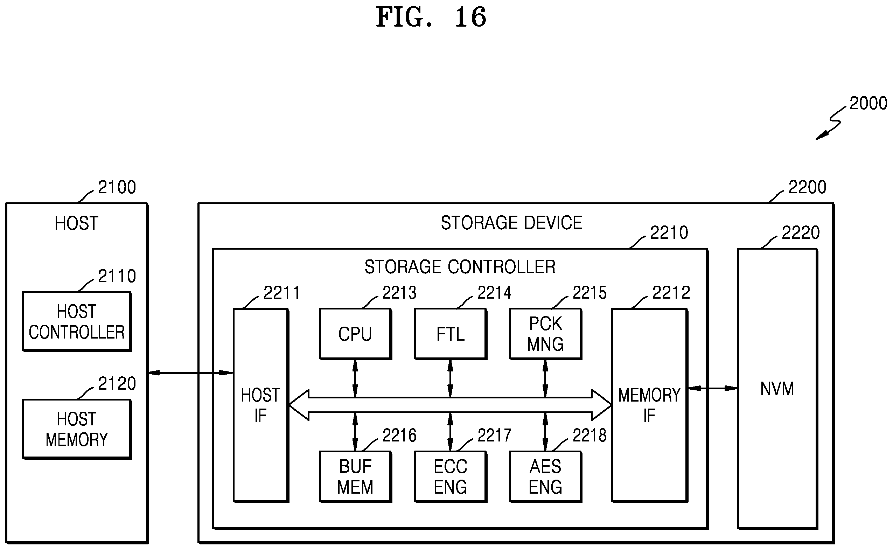

FIG. 16 is a block diagram of a storage system 2000 according to example embodiments.

Referring to FIG. 16, the storage system 2000 may include a host 2100 and a storage device 2200. The storage device 2200 may include a storage controller 2210 and a nonvolatile memory (NVM) 2220. The host 2100 may include a host controller 2110 and a host memory 2120. The host memory 2120 may function as a buffer memory temporarily storing data to be transmitted to the storage device 2200 or data transmitted from the storage device 2200.

The storage device 2200 may include storage media storing data in response to a request from the host 2100. For example, the storage device 2200 may include at least one of a solid state drive (SSD), an embedded memory, and a detachable external memory. When the storage device 2200 is an SSD, the storage device 2200 may conform to an NVM express (NVMe) standard. When the storage device 2200 is an embedded memory or an external memory, the storage device 2200 may conform to a universal flash storage (UFS) or embedded multimedia card (eMMC) standard. Each of the host 2100 and the storage device 2200 may generate and transmit a packet according to an employed standard protocol.

When the NVM 2220 of the storage device 2200 includes flash memory, the flash memory may include a two-dimensional (2D) NAND memory array or a three-dimensional (3D) (or vertical) NAND (VNAND) memory array. As another example, the storage device 2200 may include various types of NVMs. For example, the storage device 2200 may employ magnetic random access memory (MRAM), spin-transfer torque MRAM, conductive bridging random access memory (CBRAM), ferroelectric random access memory (FeRAM), phase-change random access memory (PRAM), resistive random access memory (RRAM), and other various types of memories.

According to an example embodiment, the host controller 2110 and the host controller 2110 may be implemented by separate semiconductor chips. Alternatively, in some example embodiments, the host controller 2110 and the host controller 2110 may be integrated in the same semiconductor chip. For example, the host controller 2110 may be any one of a plurality of modules included in an application processor, and the application processor may be implemented by a system on chip (SoC). In addition, the host memory 2120 may be an embedded memory provided inside the application processor or an NVM or a memory module provided outside the application processor.

The host controller 2110 may manage an operation of storing, in the NVM 2220, data (e.g., write data) in a buffer area of the host memory 2120 or storing, in the buffer area, data (e.g., read data) of the NVM 2220.

The storage controller 2210 may include a host interface 2211, a memory interface 2212, and a central processing unit (CPU) 2213. In addition, the storage controller 2210 may further include a flash translation layer (FTL) 2214, a packet manager 2215, a buffer memory 2216, an ECC engine 2217, and an advanced encryption standard (AES) engine 2218. The storage controller 2210 may further include a working memory in which the FTL 2214 is loaded, and the CPU 2213 may execute the FTL 2214 to control a write operation and a read operation on the NVM 2220.

The host interface 2211 may transmit and receive a packet to and from the host 2100. The packet transmitted from the host 2100 to the host interface 2211 may include a command, data to be stored in the NVM 2220, or the like, and the packet transmitted from the host interface 2211 to the host 2100 may include a response to the command, data read from the NVM 2220, or the like. The host interface 2211 may be implemented to conform to a standard protocol, such as peripheral component interconnect express (PCIe). The memory interface 2212 may transmit, to the NVM 2220, data to be stored in the NVM 2220 or receive, from the NVM 2220, data read from the NVM 2220. The memory interface 2212 may be implemented to conform to a standard protocol, such as Toggle or open NAND flash interface (ONFI).

The CPU 2213 is a processor and may receive data and a command signal from the outside, output a plurality of control signals to the memory interface 2212 based on the command signal, and output a clock signal and data to the memory interface 2212.

The FTL 2214 may perform various functions, such as address mapping, wear-leveling, and garbage collection. Address mapping is an operation of converting a logical address received from the host 2100 into a physical address used to actually store data in the NVM 2220. Wear-leveling is a technique of allowing blocks in the NVM 2220 to be uniformly used so as to prevent excessive deterioration of a certain block and may be implemented through a firmware technique of balancing the erase counts of physical blocks. Garbage collection is a technique of ensuring a capacity usable in the NVM 2220 through a scheme of erasing an existing block after copying valid data of the existing block to a new block.

The packet manager 2215 may generate a packet according to a protocol of an interface negotiated with the host 2100 or parse various kinds of information from a packet received from the host 2100. In addition, the buffer memory 2216 may temporarily store data to be stored in the NVM 2220 or data read from the NVM 2220. The buffer memory 2216 may be provided to the inside or outside of the storage controller 2210.

The ECC engine 2217 may perform an error detection and correction function on read data read from the NVM 2220. More particularly, the ECC engine 2217 may generate parity bits with respect to write data to be stored in the NVM 2220, and the generated parity bits may be stored in the NVM 2220 together with the write data. When data is read from the NVM 2220, the ECC engine 2217 may correct an error of the read data by using parity bits read from the NVM 2220 together with the read data and output error-corrected read data.

In example embodiments, the ECC engine 2217 may employ example embodiments described above with reference to FIGS. 1 to 15.

The AES engine 2218 may perform at least one of an encryption operation and a decryption operation on data input to the storage controller 2210, by using a symmetric-key algorithm.

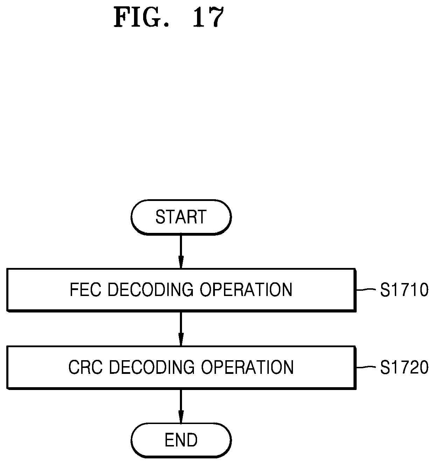

FIG. 17 is a flowchart of an operating method of an ECC circuit, according to example embodiments.

Referring to FIG. 17, the operating method of an ECC circuit may correct an error of a codeword based on an arbitrary element of a GF $GF(2^m)$ (m is an integer).

An FEC decoding operation S1710 is an operation in which the ECC circuit corrects the error of the codeword based on the arbitrary element and a first generator polynomial with respect to a first primitive polynomial included in a primitive polynomial pool. The primitive polynomial pool may include primitive polynomials having a leading term m. The first primitive polynomial may be a primitive polynomial having a multiplication complexity less than a reference value in the primitive polynomial pool. The first primitive polynomial and the first generator polynomial may be determined by the same scheme as described above with reference to FIGS. 3 to 8.

A CRC decoding operation S1720 is an operation of detecting an error of a CRC codeword error-corrected in the FEC decoding operation S1710, based on the arbitrary element and a second generator polynomial with respect to a second primitive polynomial included in the primitive polynomial pool. The second primitive polynomial may have a multiplication complexity less than the reference value and be different from the first primitive polynomial. The second primitive polynomial and the second generator polynomial may be determined by the same scheme as described above with reference to FIGS. 3 to 8.

In example embodiments, the coefficients $g_i^2$ of the second generator polynomial may be mirror-symmetrical like [Equation 14] described above.

In example embodiments, the FEC decoding operation S1710 may include a syndrome calculation operation of calculating at least one syndrome based on the codeword and the first generator polynomial, an error location calculation operation of calculating the location of an error in the codeword, based on the at least one syndrome, an error value calculation operation of calculating the error value of the codeword based on the error location, and an error correction operation of correcting an error of the codeword based on the error value. This is the same as described with reference to FIGS. 12 and 13.

In example embodiments, the CRC decoding operation S1720 may include a decoding operation of calculating a first parity data set including CRC parity data, based on the CRC codeword and the second generator polynomial, and an error detection operation of detecting an error of a message based on the first parity data set. This is the same as described with reference to FIG. 14.

According to example embodiments, the decoding operation may include a multiplication operation of multiplying the CRC codeword by the coefficients of the second generator polynomial and outputting the result values of the multiplication, a storage operation of storing the first parity data set, and an addition operation of adding the values of the first parity data set and the result values of the multiplication. This is the same as described with reference to FIG. 15.

In example embodiments, the coefficient $g_{2t_{crc}}^2$ of the leading term of the second generator polynomial may be 1.

In example embodiments, the first primitive polynomial may have the least multiplication complexity among the polynomials in the primitive polynomial pool.

In example embodiments, the second primitive polynomial may have the least multiplication complexity among the primitive polynomials excluding the first primitive polynomial.

In some example embodiments, each of the components represented by a block as illustrated in FIGS. 1 and 9-16 may be implemented as various numbers of hardware and/or firmware structures that execute respective functions described above, according to example embodiments. For example, at least one of these components may include various hardware components including a digital circuit, a programmable or non-programmable logic device or array, an application specific integrated circuit (ASIC), transistors, capacitors, logic gates, or other circuitry using use a direct circuit structure, such as a memory, a processor, a logic circuit, a look-up table, etc., that may execute the respective functions through controls of one or more microprocessors or other control apparatuses. Also, at least one of these components may further include or may be implemented by a processor such as a central processing unit (CPU) that performs the respective functions, a microprocessor, or the like. Functional aspects of example embodiments may be implemented in algorithms that execute on one or more processors. Furthermore, the components, elements, modules or units represented by a block or processing steps may employ any number of related art techniques for electronics configuration, signal processing and/or control, data processing and the like.

While aspects of example embodiments have been particularly shown and described, it will be understood that various changes in form and details may be made therein without departing from the scope of the following claims.

**Claims**

1. An error correction code circuit (100) for correcting an error of a codeword based on an element of a Galois field GF($2^m$), wherein m is an integer, the error correction code circuit (100) comprising:

   a forward error correction, FEC, decoder (122, 1200) configured to substitute the element into a first generator polynomial with respect to a first primitive polynomial, among primitive polynomials having a leading term m, that has a calculation complexity less than a reference value, correct the error of the codeword based on a result of the first generator polynomial, and output an error-corrected cyclic redundancy check, CRC, codeword; and
   a CRC decoder (121, 1400) configured to substitute the element into a second generator polynomial with respect to a second primitive polynomial among the primitive polynomials that has a calculation complexity less than the reference value and is different from the first primitive polynomial, detect an error of the CRC codeword based on a result of the second generator polynomial, and output an error-detected message,
   wherein the second generator polynomial follows [Equation 1] below

[Equation 1]

$$g_2(x) = \sum_{i=0}^{2t_{crc}} g_i^2 x^i$$

where $t_{crc}$ denotes a number of error-detectable symbols of the CRC decoder (121, 1400), and coefficients $g_i^2$ of the second generator polynomial satisfy [Equation 2] below

[Equation 2]
$$g_s^2 = g_{2t_{crc}-s}^2, where\ 0 \le s \le t_{crc} - 1.$$

2. The error correction code circuit (100) of claim 1, wherein the FEC decoder (122, 1200) comprises:

a syndrome calculation circuit (1210, 1300) configured to calculate at least one syndrome based on the codeword and the first generator polynomial;
an error location calculation circuit (1220) configured to identify a location of an error in the codeword, based on the at least one syndrome;
an error value calculation circuit (1230) configured to calculate an error value of the codeword based on the location of the error; and
an error correction circuit (1240) configured to correct the error of the codeword based on the error value.

3. The error correction code circuit (100) of claim 2, wherein the syndrome calculation circuit (1210, 1300) comprises:

a plurality of first multiplication circuits (1310_0 to 1310_5) configured to multiply the codeword and coefficients of the first generator polynomial, and output result values thereof;
a plurality of registers (1330_0 to 1330_5) storing the at least one syndrome; and
a plurality of addition circuits (1320_0 to 1320_5) configured to sum values stored in the plurality of registers and the result values of the plurality of first multiplication circuits (1310_0 to 1310_5).

4. The error correction code circuit (100) of any one of claims 1 to 3, wherein the CRC decoder (121, 1400) comprises:

a decoding circuit (1410, 1500) configured to calculate a first parity data set comprising CRC parity data, based on the CRC codeword and the second generator polynomial; and
an error detection circuit (1420) configured to detect the error of the CRC codeword based on the first parity data set.

5. The error correction code circuit (100) of claim 4, wherein the decoding circuit (1410, 1500) comprises:

a plurality of second multiplication circuits (1510_0 to 1510_4) configured to multiply the CRC codeword and coefficients of the second generator polynomial, and output result values thereof;
a plurality of registers (1530_0 to 1530_7) storing the first parity data set; and
a plurality of addition circuits (1520_0 to 1520_7) configured to perform sum values stored in the plurality of registers and the result values of the plurality of second multiplication circuits (1510_0 to 1510_4).

6. The error correction code circuit (100) of any one of claims 1 to 5, wherein a coefficient $g_{2t_{crc}}^2$ of a leading term of the second generator polynomial is 1.

7. The error correction code circuit (100) of any one of claims 1 to 6, wherein the first primitive polynomial has a lowest multiplication complexity among the primitive polynomials.

8. The error correction code circuit (100) of claim 7, wherein the second primitive polynomial has a lowest multiplication complexity among the primitive polynomials, excluding the first primitive polynomial.

9. An operating method of an error correction code circuit (100) for correcting an error of a codeword based on an element of a Galois field GF($2^m$), wherein m is an integer, the operating method comprising:

a forward error correction, FEC, decoding operation (S1710) of correcting the error of the codeword based on the element and a first generator polynomial with respect to a first primitive polynomial, among primitive polynomials having a leading term m, that has a calculation complexity less than a reference value; and
a cyclic redundancy check, CRC, decoding (1720) operation of detecting an error of a CRC codeword obtained by correcting the error of the codeword in the FEC decoding operation, based on the element and a second generator polynomial with respect to a second primitive polynomial, among the primitive polynomials, that has a calculation complexity less than the reference value and is different from the first primitive polynomial,
wherein the second generator polynomial follows [Equation 1] below

[Equation 1]

$$g_2(x) = \sum_{i=0}^{2t_{crc}} g_i^2 x^i$$

where $t_{crc}$ denotes a number of error-detectable symbols in the CRC decoding operation, and coefficients $g_i^2$ of the second generator polynomial satisfy [Equation 2] below

[Equation 2]
$$g_s^2 = g_{2t_{crc}-s}^2, where\ 0 \le s \le t_{crc} - 1.$$

10. The operating method of claim 9, wherein the FEC decoding operation (S1710) comprises:

a syndrome calculation operation of calculating at least one syndrome based on the codeword and the first generator polynomial;
an error location calculation operation of identifying a location of an error in the codeword, based on the at least one syndrome;
an error value calculation operation of calculating an error value of the codeword based on the location of the error; and
an error correction operation of correcting the error of the codeword based on the error value.

11. The operating method of claim 9 or 10, wherein the CRC decoding operation (S1720) comprises:

a decoding operation of calculating a first parity data set comprising CRC parity data, based on the CRC codeword and the second generator polynomial; and
an error detection operation of detecting the error of the CRC codeword based on the first parity data set.

12. The operating method of claim 11, wherein the decoding operation comprises:

a multiplication operation of multiplying the CRC codeword and coefficients of the second generator polynomial, and outputting result values thereof;
a storage operation of storing the first parity data set; and
an addition operation of summing values of the first parity data set and the result values of the multiplication operation.

13. The operating method of any one of claims 9 to 12, wherein a coefficient $g_{2t_{crc}}^2$ of a leading term of the second generator polynomial is 1.

14. The operating method of any one of claims 9 to 13, wherein the first primitive polynomial has, a lowest multiplication complexity among the primitive polynomials.

15. The operating method of any one of claims 9 to 14, wherein the second primitive polynomial has a lowest multiplication complexity among the primitive polynomials excluding the first primitive polynomial.

# FIG. 1

# FIG. 2

| | |
|---|---|
| CONFIGURING PRIMITIVE POLYNOMIAL POOL | S210 |

$\downarrow$

| | |
|---|---|
| DETERMINING PRIMITIVE POLYNOMIAL AND GENERATOR POLYNOMIAL OF RS FEC CODE | S220 |

$\downarrow$

| | |
|---|---|
| DETERMINING PRIMITIVE POLYNOMIAL AND GENERATOR POLYNOMIAL OF RS CRC CODE | S230 |

# FIG. 3

| NUMBER | PRIMITIVE POLYNOMIAL |
|--------|----------------------|
| P1 | $p(x)=x^8+x^4+x^3+x^2+1$ |
| P2 | $p(x)=x^8+x^5+x^3+x+1$ |
| P3 | $p(x)=x^8+x^5+x^3+x^2+1$ |
| P4 | $p(x)=x^8+x^6+x^3+x^2+1$ |
| P5 | $p(x)=x^8+x^6+x^4+x^3+x^2+x+1$ |
| P6 | $p(x)=x^8+x^6+x^5+x+1$ |
| P7 | $p(x)=x^8+x^6+x^5+x^2+1$ |
| P8 | $p(x)=x^8+x^6+x^5+x^3+1$ |
| P9 | $p(x)=x^8+x^6+x^5+x^4+1$ |
| P10 | $p(x)=x^8+x^7+x^2+x+1$ |
| P11 | $p(x)=x^8+x^7+x^3+x^2+1$ |
| P12 | $p(x)=x^8+x^7+x^5+x^3+1$ |
| P13 | $p(x)=x^8+x^7+x^6+x+1$ |
| P14 | $p(x)=x^8+x^7+x^6+x^3+x^2+x+1$ |
| P15 | $p(x)=x^8+x^7+x^6+x^5+x^2+x+1$ |
| P16 | $p(x)=x^8+x^7+x^6+x^5+x^4+x^2+1$ |

# FIG. 4

| INTERMEDIATE OUTPUT $\tilde{c}$ |
| --- |
| $\tilde{c}_0 = a_0 \& b_0$ |
| $\tilde{c}_1 = (a_0 \& b_1)\char`\^(a_1 \& b_1)$ |
| $\tilde{c}_2 = (a_0 \& b_2)\char`\^(a_1 \& b_1)\char`\^(a_2 \& b_0)$ |
| $\tilde{c}_3 = (a_0 \& b_3)\char`\^(a_1 \& b_2)\char`\^(a_2 \& b_1)\char`\^(a_3 \& b_0)$ |
| $\tilde{c}_4 = (a_0 \& b_4)\char`\^(a_1 \& b_3)\char`\^(a_2 \& b_2)\char`\^(a_3 \& b_1)\char`\^(a_4 \& b_0)$ |
| $\tilde{c}_5 = (a_0 \& b_5)\char`\^(a_1 \& b_4)\char`\^(a_2 \& b_3)\char`\^(a_3 \& b_2)\char`\^(a_4 \& b_1)\char`\^(a_5 \& b_0)$ |
| $\tilde{c}_6 = (a_0 \& b_6)\char`\^(a_1 \& b_5)\char`\^(a_2 \& b_4)\char`\^(a_3 \& b_3)\char`\^(a_4 \& b_2)\char`\^(a_5 \& b_1)\char`\^(a_6 \& b_0)$ |
| $\tilde{c}_7 = (a_0 \& b_7)\char`\^(a_1 \& b_6)\char`\^(a_2 \& b_5)\char`\^(a_3 \& b_4)\char`\^(a_4 \& b_3)\char`\^(a_5 \& b_2)\char`\^(a_6 \& b_1)\char`\^(a_7 \& b_0)$ |
| $\tilde{c}_8 = (a_1 \& b_7)\char`\^(a_2 \& b_6)\char`\^(a_3 \& b_5)\char`\^(a_4 \& b_4)\char`\^(a_5 \& b_3)\char`\^(a_6 \& b_2)\char`\^(a_7 \& b_1)$ |
| $\tilde{c}_9 = (a_2 \& b_7)\char`\^(a_3 \& b_6)\char`\^(a_4 \& b_5)\char`\^(a_5 \& b_4)\char`\^(a_6 \& b_3)\char`\^(a_7 \& b_2)$ |
| $\tilde{c}_{10} = (a_3 \& b_7)\char`\^(a_4 \& b_6)\char`\^(a_5 \& b_5)\char`\^(a_6 \& b_4)\char`\^(a_7 \& b_3)$ |
| $\tilde{c}_{11} = (a_4 \& b_7)\char`\^(a_5 \& b_6)\char`\^(a_6 \& b_5)\char`\^(a_7 \& b_4)$ |
| $\tilde{c}_{12} = (a_5 \& b_7)\char`\^(a_6 \& b_6)\char`\^(a_7 \& b_5)$ |
| $\tilde{c}_{13} = (a_6 \& b_7)\char`\^(a_7 \& b_6)$ |
| $\tilde{c}_{14} = a_7 \& b_7$ |

EP 4 657 758 A1

EP 4 657 758 A1

## FIG. 5

| INTERMEDIATE OUTPUT $\tilde{c}$ |
|---|
| $\tilde{c}_0 = a_0 \& b_0$ |
| $\tilde{c}_1 = (a_0\&b_1)$ ^ ~~$(a_1\&b_1)$~~ |
| $\tilde{c}_2 = (a_0\&b_2)$ ^ ~~$(a_1\&b_1)$~~ ^ ~~$(a_2\&b_0)$~~ |
| $\tilde{c}_3 = (a_0\&b_3)$ ^ ~~$(a_1\&b_2)$~~ ^ ~~$(a_2\&b_1)$~~ ^ ~~$(a_3\&b_0)$~~ |
| $\tilde{c}_4 = (a_0\&b_4)$ ^ ~~$(a_1\&b_3)$~~ ^ ~~$(a_2\&b_2)$~~ ^ ~~$(a_3\&b_1)$~~ ^ $(a_4\&b_0)$ |
| $\tilde{c}_5 = (a_0\&b_5)$ ^ ~~$(a_1\&b_4)$~~ ^ ~~$(a_2\&b_3)$~~ ^ ~~$(a_3\&b_2)$~~ ^ $(a_4\&b_1)$ ^ ~~$(a_5\&b_0)$~~ |
| $\tilde{c}_6 = (a_0\&b_6)$ ^ ~~$(a_1\&b_5)$~~ ^ ~~$(a_2\&b_4)$~~ ^ ~~$(a_3\&b_3)$~~ ^ $(a_4\&b_2)$ ^ ~~$(a_5\&b_1)$~~ ^ ~~$(a_6\&b_0)$~~ |
| $\tilde{c}_7 = (a_0\&b_7)$ ^ ~~$(a_1\&b_6)$~~ ^ ~~$(a_2\&b_5)$~~ ^ ~~$(a_3\&b_4)$~~ ^ $(a_4\&b_3)$ ^ ~~$(a_5\&b_2)$~~ ^ ~~$(a_6\&b_1)$~~ ^ $(a_7\&b_0)$ |
| $\tilde{c}_8 =$ ~~$(a_1\&b_7)$~~ ^ ~~$(a_2\&b_6)$~~ ^ ~~$(a_3\&b_5)$~~ ^ $(a_4\&b_4)$ ^ ~~$(a_5\&b_3)$~~ ^ ~~$(a_6\&b_2)$~~ ^ $(a_7\&b_1)$ |
| $\tilde{c}_9 =$ ~~$(a_2\&b_7)$~~ ^ ~~$(a_3\&b_6)$~~ ^ $(a_4\&b_5)$ ^ ~~$(a_5\&b_4)$~~ ^ ~~$(a_6\&b_3)$~~ ^ $(a_7\&b_2)$ |
| $\tilde{c}_{10} =$ ~~$(a_3\&b_7)$~~ ^ $(a_4\&b_6)$ ^ ~~$(a_5\&b_5)$~~ ^ ~~$(a_6\&b_4)$~~ ^ $(a_7\&b_3)$ |
| $\tilde{c}_{11} = (a_4\&b_7)$ ^ ~~$(a_5\&b_6)$~~ ^ ~~$(a_6\&b_5)$~~ ^ $(a_7\&b_4)$ |
| $\tilde{c}_{12} =$ ~~$(a_5\&b_7)$~~ ^ ~~$(a_6\&b_6)$~~ ^ $(a_7\&b_5)$ |
| $\tilde{c}_{13} =$ ~~$(a_6\&b_7)$~~ ^ $(a_7\&b_6)$ |
| $\tilde{c}_{14} = a_7\&b_7$ |

# FIG. 6

| $P1: p(x) = x^8 + x^4 + x^3 + x^2 + 1$ | $P3: p(x) = x^8 + x^5 + x^3 + x^2 + 1$ |
|---|---|
| $c_0 = \tilde{c}_0 \wedge \tilde{c}_8 \wedge \tilde{c}_{12} \wedge \tilde{c}_{13} \wedge \tilde{c}_{14}$ | $c_0 = \tilde{c}_0 \wedge \tilde{c}_8 \wedge \tilde{c}_{11} \wedge \tilde{c}_{13}$ |
| $c_1 = \tilde{c}_1 \wedge \tilde{c}_9 \wedge \tilde{c}_{13} \wedge \tilde{c}_{14}$ | $c_1 = \tilde{c}_1 \wedge \tilde{c}_9 \wedge \tilde{c}_{12} \wedge \tilde{c}_{14}$ |
| $c_2 = \tilde{c}_2 \wedge \tilde{c}_8 \wedge \tilde{c}_{10} \wedge \tilde{c}_{12} \wedge \tilde{c}_{13}$ | $c_2 = \tilde{c}_2 \wedge \tilde{c}_8 \wedge \tilde{c}_{10} \wedge \tilde{c}_{11}$ |
| $c_3 = \tilde{c}_3 \wedge \tilde{c}_8 \wedge \tilde{c}_9 \wedge \tilde{c}_{11} \wedge \tilde{c}_{12}$ | $c_3 = \tilde{c}_3 \wedge \tilde{c}_8 \wedge \tilde{c}_9 \wedge \tilde{c}_{12} \wedge \tilde{c}_{13}$ |
| $c_4 = \tilde{c}_4 \wedge \tilde{c}_8 \wedge \tilde{c}_9 \wedge \tilde{c}_{10} \wedge \tilde{c}_{14}$ | $c_4 = \tilde{c}_4 \wedge \tilde{c}_9 \wedge \tilde{c}_{10} \wedge \tilde{c}_{13} \wedge \tilde{c}_{14}$ |
| $c_5 = \tilde{c}_5 \wedge \tilde{c}_9 \wedge \tilde{c}_{10} \wedge \tilde{c}_{11}$ | $c_5 = \tilde{c}_5 \wedge \tilde{c}_8 \wedge \tilde{c}_{10} \wedge \tilde{c}_{13} \wedge \tilde{c}_{14}$ |
| $c_6 = \tilde{c}_6 \wedge \tilde{c}_{10} \wedge \tilde{c}_{11} \wedge \tilde{c}_{12}$ | $c_6 = \tilde{c}_6 \wedge \tilde{c}_9 \wedge \tilde{c}_{11} \wedge \tilde{c}_{14}$ |
| $c_7 = \tilde{c}_7 \wedge \tilde{c}_{11} \wedge \tilde{c}_{12} \wedge \tilde{c}_{13}$ | $c_7 = \tilde{c}_7 \wedge \tilde{c}_{10} \wedge \tilde{c}_{12}$ |

EP 4 657 758 A1

# FIG. 7

| P1 | P2 | P3 | P4 | P5 | P6 | P7 | P8 | P9 | P10 | P11 | P12 | P13 | P14 | P15 | P16 |
|----|----|----|----|----|----|----|----|----|-----|-----|-----|-----|-----|-----|-----|
| (28,5) | (33,6) | (26,5) | (32,7) | (29,7) | (30,6) | (31,7) | (36,7) | (29,6) | (32,7) | (30,6) | (32,6) | (32,7) | (33,6) | (30,6) | (30,6) |

# FIG. 8

EP 4 657 758 A1

| $P1:p(x)=x^8+x^4+x^3+x^2+1$ | $P3:p(x)=x^8+x^5+x^3+x^2+1$ |
|---|---|
| $g(x) = (x-1)(x-a^2)(x-a^3)(x-a^4)(x-a^5)$ $= 38 + 227x + 32x^2 + 218x^3 + x^4 + 63x^5 + x^6$ | $g(x) = (x-1)(x-a^2)(x-a^3)(x-a^4)(x-a^5)$ $= 228 + 212x + 63x^2 + 96x^3 + 81x^4 + 63x^5 + x^6$ |

# FIG. 9

EP 4 657 758 A1

FIG. 10

EP 4 657 758 A1

# FIG. 11

EP 4 657 758 A1

EP 4 657 758 A1

# FIG. 12

1200

CW → SYNDROME CALCULATION CIRCUIT (1210) → ERROR LOCATION CALCULATION CIRCUIT (1220) → ERROR VALUE CALCULATION CIRCUIT (1230) → ERROR CORRECTION CIRCUIT (1240) → CRC_CW

# FIG. 13

# FIG. 14

<u>1400</u>

```
CRC_CW ──→ ┌──────────────┐   ┌──────────────────┐
           │   DECODING   │ ──→ │ ERROR DETECTION  │ ──→ MSG
           │   CIRCUIT    │   │     CIRCUIT       │
           └──────────────┘   └──────────────────┘
              1410               1420
```

FIG. 15

EP 4 657 758 A1

# FIG. 16

EP 4 657 758 A1

# FIG. 17

```
        ┌─────────────┐
        │    START    │
        └─────────────┘
               │
               ▼
┌───────────────────────────────────┐
│      FEC DECODING OPERATION        │───S1710
└───────────────────────────────────┘
               │
               ▼
┌───────────────────────────────────┐
│      CRC DECODING OPERATION        │───S1720
└───────────────────────────────────┘
               │
               ▼
        ┌─────────────┐
        │     END     │
        └─────────────┘
```

Europäisches
Patentamt

European
Patent Office

Office européen
des brevets

# EUROPEAN SEARCH REPORT

**Application Number**

EP 25 16 9384

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | SHARMA DEBENDRA DAS ET AL: "Pipelined and Partitionable Forward Error Correction and Cyclic Redundancy Check Circuitry Implementation for PCI Express 6.0 and Compute Express Link 3.0", IEEE MICRO, IEEE SERVICE CENTER, LOS ALAMITOS, CA, US, vol. 44, no. 2, 9 November 2023 (2023-11-09), pages 50-59, XP011965184, ISSN: 0272-1732, DOI: 10.1109/MM.2023.3328832 [retrieved on 2023-11-10] * figures 1(a)-(c) * * page 51 - page 58 * ----- | 1-15 | INV. H03M13/09 H03M13/15 H03M13/29 H03M13/00 |
| X | US 5 446 745 A (GIBBS VICKIE L [US]) 29 August 1995 (1995-08-29) * figures 2, 4 * * column 2 - column 5 * * claims 1-7 * ----- | 1-15 | |
| | | | TECHNICAL FIELDS SEARCHED (IPC) |
| A | US 10 623 187 B2 (ERICSSON TELEFON AB L M [SE]) 14 April 2020 (2020-04-14) * column 9 - column 16 * ----- | 1-15 | H03M |

The present search report has been drawn up for all claims

| Place of search | Date of completion of the search | Examiner |
|---|---|---|
| Munich | 24 September 2025 | Kraska, Nora |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

.............................................................................

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 25 16 9384

This annex lists the patent family members relating to the patent documents cited in the above-mentioned European search report.
The members are as contained in the European Patent Office EDP file on
The European Patent Office is in no way liable for these particulars which are merely given for the purpose of information.

24-09-2025

| Patent document cited in search report | | Publication date | Patent family member(s) | | Publication date |
|---|---|---|---|---|---|
| US 5446745 | A | 29-08-1995 | NONE | | |
| US 10623187 | B2 | 14-04-2020 | CN | 107592968 A | 16-01-2018 |
| | | | EP | 3292653 A1 | 14-03-2018 |
| | | | KR | 20170137872 A | 13-12-2017 |
| | | | US | 2018069706 A1 | 08-03-2018 |
| | | | WO | 2016177385 A1 | 10-11-2016 |

EPO FORM P0459

For more details about this annex : see Official Journal of the European Patent Office, No. 12/82